Europäisches Patentamt

European Patent Office

Office européen des brevets

(11) Publication number: **0 142 586**
**A1**

## (12) EUROPEAN PATENT APPLICATION

(21) Application number: 83307036.0

(22) Date of filing: 17.11.83

(51) Int. Cl.⁴: **H 03 H 11/12**
**H 03 B 5/20**

(43) Date of publication of application:
29.05.85 Bulletin 85/22

(84) Designated Contracting States:
AT BE CH DE FR GB IT LI LU NL SE

(71) Applicant: BUDAPESTI RADIOTECHNIKAI GYAR
Polgár u. 8-10
H-1033 Budapest(HU)

(72) Inventor: Kovacs, Sandor
Ferenc krt. 2/4
1092 Budapest(HU)

(72) Inventor: Fozo, Arpad
Himzo u. 6
1039 Budapest(HU)

(74) Representative: Boon, Graham Anthony et al,
Elkington and Fife High Holborn House 52/54 High
Holborn
London, WC1V 6SH(GB)

(54) A filter arrangement with active elements.

(57) An active filter arrangement particularly for the reception and transmission of signal sequences, which comprises three feed back operational amplifiers (1,2,3) connected in a closed loop chain. The feedback impedance of one of the amplifiers (1) comprises an ohmical and a capacitive member connected in parallel, while another (2) is fed back by a capacitive impedance. At least one of the capacitive branches includes an RC member. The quality factor can be changed by the adjustment of the ohmical branch while the frequency can be changed by adjusting the coupling between the operational amplifiers within wide ranges. One of the operational amplifiers comprises a feedback circuit (7) controlled by a pulse width modulator (8) by means of which an oscillator mode of operation can be set and the frequency of oscillation will be that of the filter. The oscillator amplitude can be controlled by means of the pulse width modulator (8).

The adjustment of the frequency and/or the quality factor can be carried out by means of an attenuator comprising a series chain of resistors ($R_0$ to $R_n$) coupled to an operational amplifier (17) which arrangement is capable of realizing virtual ground potential with discretely changable location in the chain.

The active filter has a preferable field of application in a circuit arrangement for generating and receiving signal sequences in radio transmitter-receiver systems.

./...

Fig. 1

A FILTER ARRANGEMENT WITH ACTIVE ELEMENTS

The invention relates to the field of electronic telecommunication technique and in this field it relates to applications in which sequential signal series are received, detected and generated, and more particularly to a filter arrangement with active elements which can be used both as a band pass filter and as an oscillator. The invention relates also to an outstanding field of application of the filter arrangement i.e. to a circuit arrangement for the reception and generation of sequential signal series. Furthermore the invention relates to a circuit arrangement for adjusting discrete resistance values which is closely related to the implementation of the filter arrangement, but which can not be limited to such applications. ·

The reception and generation of sequential signal series is required in a large number of applications in the field of telecommunication technique, particularly in which the number of participants of a free telecommunication system is substantially higher than the number of connections which can be simultaneously established among the participants. The individual members of the system can be reached (called) by sending a specific secuential calling signal series and by the selective identification of such signals. Although the sequential call can not be considered to be the only way of solving the task of selective interconnection, owing to its certain advantages the sequential calling system has gained a wide acceptance.

In sequential calling systems a selected sequence of predetermined frequencies and predetermined duration is transmitted and this sequence should be identified by the called station. In case of an outgoing call such sequences should be generated.

In sequential calling systems there have been certain problems in connection with the design of filter units, mainly in connection with the limited speed of switching over to other frequencies and with insufficient stability. The tuning range and the selectivity of conventional band pass filters made of inductive coils and capacitors have been limited, and additional problems have come from the temperature dependence of the inductive coils and from the large size of the coils, which has acted against the general tendency of miniaturization.

Owing to these grounds the application of filters with active elements has been required. In the Hungarian patent 173,165 the implementation of an adjustable inductive reactance by means of active elements is described. This patent has eliminated some of the drawbacks of conventional filters using resonance circuits, however, it could not overcome all drawbacks. According to this patent the use of a standard inductance is required from which the various reactance values are provided by means of transformation. As it is known, the quality factor of an inductance is dependent on frequency and during transformation not only the inductance but also the quality factor thereof will be transformed, which can limit the possibility of applications. The transformation can not compensate the temperature dependency, either.

There are known filter arrangements with active elements which do not comprise any inductance and consist of a number of operational amplifiers arranged in a closed loop. All of these operational amplifiers have respective feedback circuits. The basic circuit and the design of such a modern active filter arrangement is described in the description of the universal active filter type UAF 41 made by the Burr-Brown Research Corporation (U.S.A.) published in publication PDS-359 of the Corporation (July, 1978).

This universal active filter comprises three operational amplifiers connected in a chain, in which the second and third operational amplifiers being fed back by respective capacitors. From the formulae given for the filter design, it can be seen that in band-pass filter mode the frequency of the filter can be changed by the adjustment of two separate resistors, and the adjustment of the frequency exerts also an influence on the quality factor (selectivity) of the filter. The adjustment of the quality factor can be made by a separate resistor, but due to the frequency dependency the quality factor can not be adjusted independent of the frequency.

In reception of sequential signal series the discrete frequencies are rather close to each other and they are chosen in such a way that the individual frequencies can be distinguished by means of filter elements having identical relative bandwidth properties.

It would be most preferable, if the adjustment of the quality factor were independent from the adjustment of the frequency, and if the frequency adjustment were realizable by changing the value of a single component only.

In active filters but also in other fields of applications certain problems are connected with the setting of resistances to take predetermined discrete values. The usage of mechanical switching elements are excluded from several fields of applications due to their large sizes, slow operation and instable contact resistances. Although the electronic switches are sufficiently reliable, in case of connecting a plurality of resistances to a common

- 5 -    0142586

circuit point, shunt paths may come to being and in on-state such switches have relatively high channel resistances, which factors together may cause difficulties in the accurate adjustment of the required resistances. The electronic switches are temperature-dependent and it is rather difficult to provide an independent control for the switching elements. The application of active filters requires the usage of circuits providing predetermined switched resistance values by which the various filter parameters can be adjusted.

Apart from the problems connected with the reception of sequential signal series, the generation of such series is also rather problematic because for a proper transmission signal sequences are required which comprise signals with different frequencies started precisely one after the other. Owing to the built-in inductive coils, oscillators built from LC members have the problems discussed above in connection with filters used for reception. There are already known oscillators built by RC members (see e.g. Tietsche-Schenk: Analog and Digital Circuits, Technical Press, Budapest, 1973) and oscillators built by active filters which all provide sine waveforms.

There are several problems known in connection with such oscillators. For the starting of the oscillation a certain extent of overcoupling is required so that the signal amplitude can increase exponentially from the everywhere available noise level. For reaching a constant amplitude, the coupling should be decreased until the equilibrum state is reached. This is achieved either by increasing the signal level until the circuit components start to behave  non-linearly or by using a separate amplitude regulating unit.

The overcoupling during the start of oscillation may result in a shift in the operating frequency which decreases the security of the transmission and increases thereby the hazard of false signal identification. The decreased extent of overcoupling, however, increases the running up time.

An other problem is rooted in the regulation of the signal level. In applications using linear elements in the oscillator circuit, the value of at least one of the components determining the extent of feedback (coupling) is changed by an analog regulation (by using a high error signal amplification) until the required level is reached.

Such level control has generally a high time constant, and the non-linearity, inaccuracy and temperature dependency of the components used in the control circuit may result in the instability of the signal level or in increasing the adjustment problems during manufacture.

Since in most radio stations the reception and generation of signal sequences should both be solved, there have been already proposals in which the selective element used for the selective reception was used as the selective (frequency determining) element also for the signal generation. Such an example with an LC filter is described in the German publication DE AS 2.033.004.

Such a combination has never been used, however, for applications using active filters.

The object of the present invention is to provide circuit arrangements which can solve the above sketched problems and which can substantially reduce the complexity of circuitry required for the reception and the transmission of sequential signal series.

According to the first aspect of the invention a filter arrangement with active elements have been provided, which comprises three operational amplifiers connected in a closed-loop chain, in which two of the amplifiers have a capacitive and the third one has an ohmical feedback, and according to the invention the capacitive feedback has been used in the first and second operational amplifiers in such a way that the first capacitive feedback impedance includes two parallel branches of which the first has a capacitive reactance (being a capacitor or a series RC member) and the second is an ohmical circuit preferably a T-attenuator, and the second capacitive feedback impedance is a series RC member. This second impedance can be realized by a capacitor, too, if in the first impedance the capacitive branch comprises a series RC member. By using such an arrangement the adjustment of the filter frequency can be effected by a single member e.g. by a coupling element, and this adjustment exerts only a negligible influence on the value of the quality factor, which latter can be adjusted by the ohmical branch of the feedback impedance.

According to an other inventive recognition the outputs of the first two operational amplifiers can be interconnected by a controllable feedback circuit. By the insertion of the controllable feedback circuit the filter used heretofore for the reception, will be converted into an oscillator, and the frequency of the oscillator will be adjustable by the same element and in the same way as in case of filter operation. This feature provides for the substantial combination of the circuits used for reception and transmission and for the common handling.

The controlled feedback circuit, which can be made by a voltage controlled attenuator without any phase-shift, can be controlled not only by means of an analog control but preferably by a digital control setting alternatively two discrete states. The precise adjustment of the oscillation level can be made by a pulse-width modulator defining the discrete states. In less sophisticated applications the feedback circuit can be made by a simple controlled limiter circuit.

A further aspect of the present invention relates to a preferable application of the filter arrangement, which is a circuit arrangement for the reception and transmission of sequential signal series, and the circuit arrangement comprises an amplitude limiter, selector and generator audio path switches, a level comparator, a control unit, a transmit/receive program store and an operator unit, in which according to the invention the mode determining output of the control unit is coupled to control inputs of said path switches and to mode control input of a filter block representing the active filter arrangement, the frequency adjusting input of the filter block, and the quality factor determining output of the control unit is coupled to the quality factor adjusting input of the filter block, furthermore the output of the selector audio path switch is connected to the signal input of the filter block, the input of the generator audio path switch is coupled to the oscillator output of the filter block and the output of the level comparator is connected to code receiving input of the control unit.

A further aspect of the present invention relates to a circuit arrangement for the setting of discrete resistance values which can well be used, as means for changing the frequency and the quality factor of the active filter, but it can be used also in other applications, and this circuit arrangement comprises resistors inserted in a series chain and switching elements connected to internal terminals of the chain, and according to the invention the arrangement comprises an operational amplifier with an output connected to an end terminal of the chain and with an input connected to a common terminal of the switching elements and with an other input connected to a ground potential, and the switching elements have respective control inputs of which only one can be enabled at a time.

The present invention can provide for the substantial reduction in complexity during reception and transmission of sequential signal series concerning the number and size of the components and the handling, and at the same time the drawbacks of conventional technical solutions have been remarkably reduced.

The invention will now be described by way of examples in connection with preferable embodiments thereof, in which reference will be made to the accompanying drawings. In the drawing:

FIG. 1        shows the overall block diagram of the active filter according to the invention,

FIGs. 2a and 2b   show two examples for the implementation of the first capacitive feedback impedance,

FIG. 3        shows an embodiment of the second capacitive feedback impedance,

FIG. 4        shows an embodiment of the coupling member,

FIG. 5 and 6   show two embodiments of a discrete resistance setting circuit using an operational amplifier,

FIG. 7        shows the circuit diagram of a pulse-width modulator for controlling the feedback impedance, and

FIG. 8        shows a circuit arrangement using the active filter shown in FIG. 1 for the reception and generation of sequential signal series.

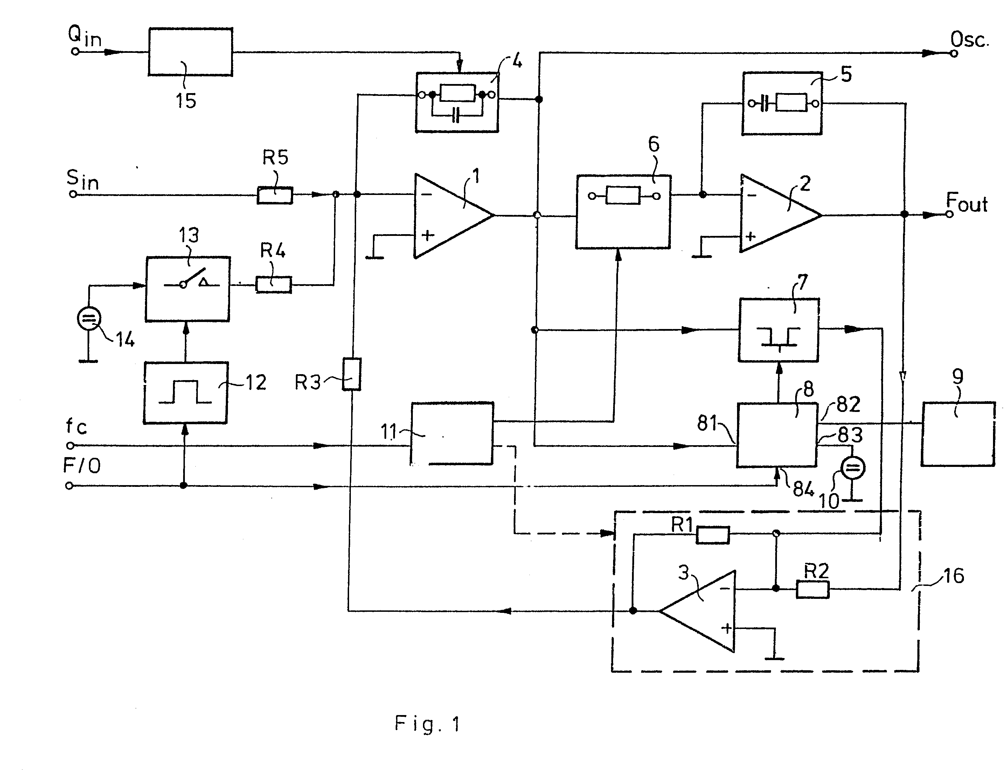

Reference is made now to Fig. 1 which shows the block diagram of the active filter and the oscillator made according to the invention. The main portion of the arrangement is formed by three operational amplifiers 1, 2 and 3 coupled in series in a closed loop. A first capacitive feedback impedance 4 is connected in parallel with the first operational amplifier 1 and a second capacitive feedback impedance 5 is connected in parallel with the second operational amplifier 2. The third operational amplifier 3 is fed back by resistor R1. There is a coupling member 6 between the first and second operational amplifiers 1 and 2 which does not provide any phase-shift such as a resistor, a current divider or in given cases an amplifier or any other attenuator with zero phase-shift. The output of the second operational amplifier 2 forms a filter output $F_{out}$ for the whole arrangement, and this output is coupled through resistor R2 to the inverted input of the third operational amplifier 3. The output of the third operational amplifier 3 is connected through a resistor R3 to the inverted input of the first operational amplifier 1, and this input is connected through a resistor R5 to signal input $S_{in}$ of the active filter. The output of the first operational amplifier 1 forms the oscillator output Osc of the circuit arrangement.

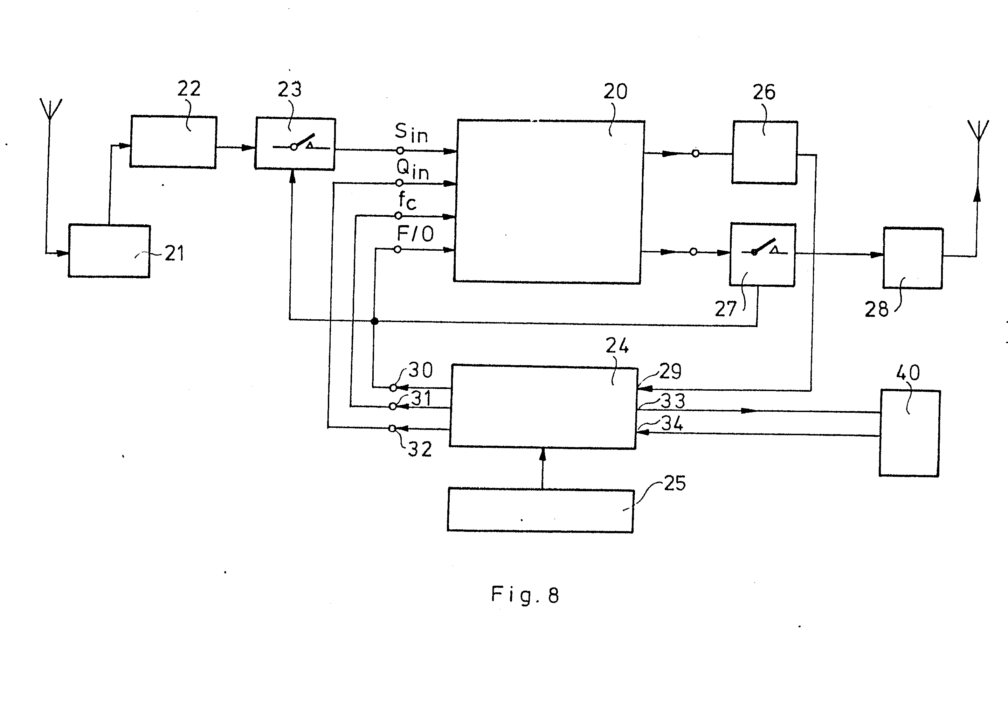

There is provided between the output of the first operational amplifier 1 and the inverted input of the third operational amplifier 3 a controlled feedback circuit 7 having a state controlled by a pulse-width modulator 8. The feedback circuit 7 is made preferably by the source-drain channel of a field effect transistor. When the feedback circuit 7 is operatively inserted, the circuit arrangement starts to operate as an oscillator. The task of the pulse-width modulator 8 is to maintain a constant amplitude for the oscillation, and the modulator 8 has a first input 81 connected to the output of the first operational amplifier 1, a second input 82 connected to a clock 9, a third input 83 connected to a reference voltage source 10 and a fourth input 84 coupled to a mode control input F/O of the circuit arrangement. An embodiment of the pulse-width modulator 8 will be described in connection with Fig. 7.

For adjusting the frequency of the active filter a frequency adjusting switch 11 is connected to a control input of the coupling member 6 to decide the output current thereof, and the frequency adjusting switch 11 receives a control signal through input $f_c$ which corresponds to the required frequency. An alternative embodiment for the frequency adjustment is illustrated by a dashed line in Fig. 1, in which the switch 11 controls the signal level passing through the operational amplifier 3 fed back by the resistors R1 and R2.

In the generator mode of operation in order

- 15 -

to ensure a fast starting of the oscillation with 0142586 minimum distortion, an energy corresponding to the required oscillator amplitude is supplied to the oscillating system which has no energy when being switched on. This is achieved by connecting the mode control input F/O to starting input of a pulse-width adjusting block 12 (preferably a monostable) to enable this block for a predetermined periode of time when the oscillation mode of operation is set. The output of the block 12 is coupled to control input of a switch 13 which connects a reference source 14 through resistor R4 to the inverting input of the first operational amplifier 1 for the predetermined period.

In Fig. 1 the capacitive feedback impedance 4 is illustrated as an impedance with adjustable value. The control input defining the impedance is connected to a quality coefficient adjusting switch 15, the state of which is defined by an outer control signal applied the input Q in.

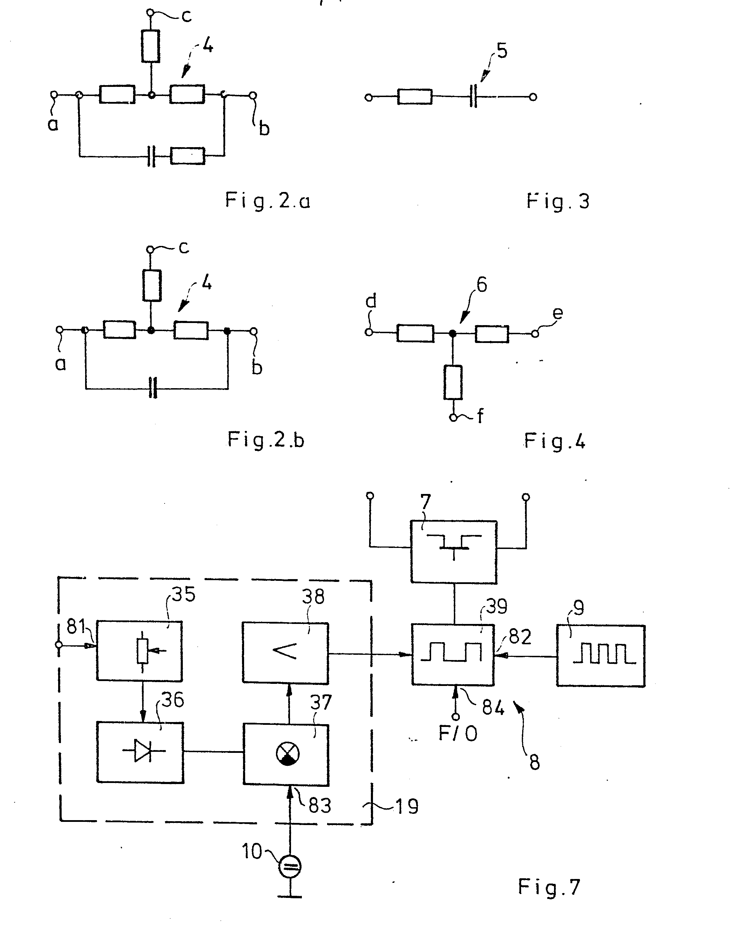

Figs. 2a and 2b show two embodiments for the capacitive feedback impedance 4. Both arrangements comprise a capacitive branch and a parallel ohmical branch, in which the ohmical branch is made by a T-attenuator with terminals a and b identical with the two terminals of the impedance 4 and a further terminal c coupled to the quality coefficient adjusting switch 15. The two embodiments differ in the capacitive branch because in Fig. 2a this branch is formed by a series RC member and in Fig. 2b by a capacitor. The attenuation of the T-attenuator defines the quality coefficient (bandwidth and selectivity) of the active filter.

Fig. 3 shows the capacitive feedback impedance 5 which is made by a series RC member. If a resistor is arranged in series with the capacitor of the capacitive feedback impedance 4, the series resistor of the capacitive feedback impedance 5 can be omitted.

Fig. 4 shows a preferable embodiment of the coupling member 6 of Fig. 1 which consists of a T-attenuator with terminals $d$ and $e$ coupled to the first and second operational amplifiers 1 and 2, respectively. Terminal $f$ of the attenuator is connected to the output of the frequency adjusting switch 11.

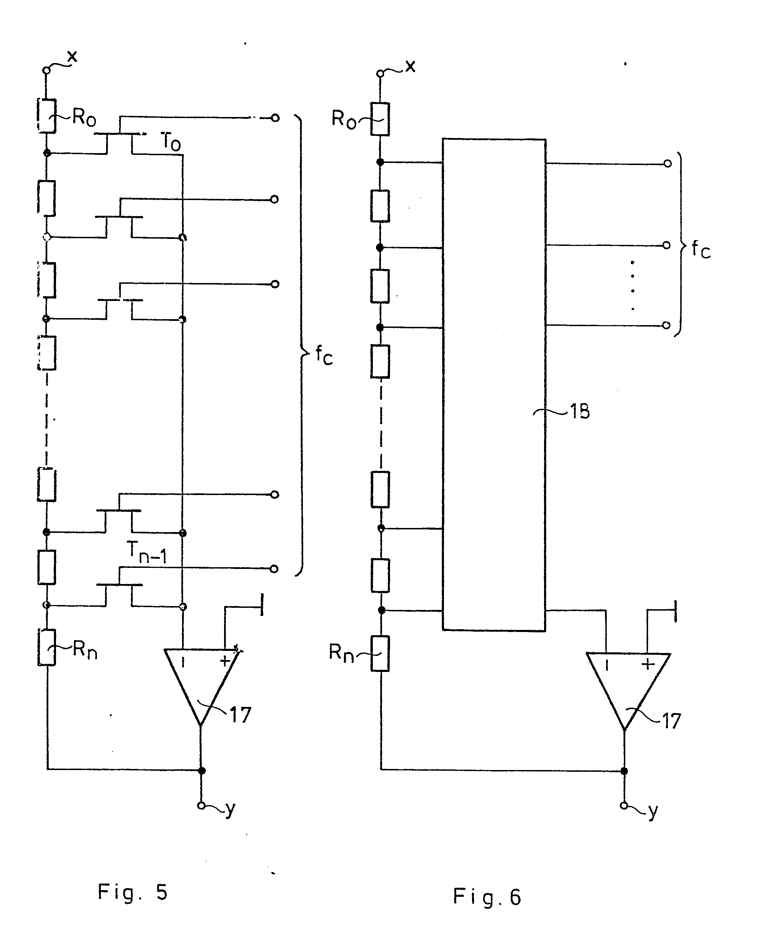

Figs. 5 and 6 show the circuit diagram of two embodiments of a controlled resistor according to the invention which can be used both as a two-pole and as a four-pole and which can be used to form the frequency adjusting switch 11, the quality coefficient adjusting switch 15 and a block 16 including the third operational amplifier 3 and the resistors R1 and R2.

Both circuits comprise respective resistor chains with resistors $R_o \ldots R_n$ and operational amplifier 17 the output of which is connected to the free end of the last resistor $R_n$ and this

connection forms terminal $y$ of the circuit. The circuit has an other terminal $x$ formed by the free end of the resistor $R_0$. Each internal connection point of the resistor chain is coupled to drain electrode of respective field effect transistors $T_0 \ldots T_{n-1}$ in the circuit shown in Fig. 5. The source electrodes of all transistors $T_0 \ldots T_{n-1}$ are interconnected and coupled to the inverting input of the operational amplifier 17. The non-inverting input is coupled to the ground. The gate electrodes form respective terminals and they are used as the frequency determining inputs fc.

The circuit shown in Fig. 6 differs from that of Fig. 5 in that instead of the field effect transistors an analog multiplexer 18 is used which connects that one of its outputs to the inverting input of the operational amplifier 17 which is selected by the digital code applied to the inputs fc. The analog multiplexer 18 can be implemented if the gating inputs of the circuit shown in Fig. 5 are coupled to respective outputs of a digital multiplexer, and logical levels are used that can ensure the turning on of the field effect transistors. In that case the digital inputs are formed by the control inputs of the multiplexer.

A common feature of the two embodiments lies in that only the selected one of the tapping points of the resistor chain is connected to the inverting input of the operational amplifier 17, and this selected point acts in operation as a virtual grounded terminal. When the resistor chain is seen from the terminal $\underline{x}$, this way of operation means that only the portion of the chain between the terminal $\underline{x}$ and the selected tapping point can act as a load, and this portion forms the resulting resistance seen from terminal x. If the circuit arrangement is considered from the viewpoint of the signal passage between terminals $\underline{x}$ and $\underline{y}$ i.e. as a four-pole network, then the value of the transfer function depends on the position of the selected tapping point in the chain.

Fig. 7 shows an exemplary embodiment of the pulse-width modulator 8. The pulse-width modulator 8 comprises a level detector and control circuit 19 and a modulator 39 with a control input connected to the output of the circuit 19. The circuit 19 has an input 81 coupled to the output of the first operational amplifier 1. The reference source 10 is connected to input 83 of the level detector and control circuit 19.

In operation in response to an enable signal coupled from the mode control input F/O to the input 84 the modulator 39 passes the pulses of the clock 9 to the control input of the controlled feedback circuit 7 with a pulse duration determined by the controlled signal applied to the control input of the modulator 39.

The level detector and control circuit 19

comprises a level setting circuit 35 for enabling the adjustment of the signal level, and the input of the circuit 35 forms the input 81. The output of the level setting circuit 35 is connected to a level detector 36 which provides a DC voltage proportional to the signal level. The level detector 36 can be implemented e.g. by a rectifier with integrating properties. The output of the level detector 36 is coupled to non-inverting input of a difference circuit 37. The inverting input of the difference circuit 37 forms the input 83 connected to the reference voltage source 10. The output of the difference circuit 37 is connected through an error signal amplifier 38 to the modulation control input of the pulse width modulator 39.

Fig. 8 shows a typical example for the application of the active filter and oscillator circuit according to the invention which is capable both of receiving the sequential calls and of generating calling signals for radio transceivers used in radio telephone systems. In this example the whole circuit shown in Fig. 1 is symbolised as block 20 with input and output terminals designated in line with the labels of Fig. 1.

The transceiver has a receiver 21 with an audio output coupled through an amplitude limiter 22 to audio path switching input of selector 23. The audio path switching output of the selector 23 is connected to the signal input $S_{in}$ of the block 20. A control unit 24 controls the selective calling and the generation of signals on the basis of a stored program, and the required coded porgrams are provided by a T/R code program store 25. The control unit 24 determines whether the actual mode of operation includes code reception or transmission. This determination of the actual mode is carried out by a command signal sent to the mode control input F/O of the block 20. This commend signal is sent to the control input of the audio path switching selector 23 to set it in mode of reception and to control input of a generator audio path switch 27 to set it in generator mode.

The filter output $F_{out}$ of the block 20 is connected to the input of a level comparator 26, and the output of the comparator 26 is coupled to code receiving input 29 of the control unit 24. The output of the generator audio path switch 27 is connected to modulator input of transmitter 28. In accordance with the stored program the control unit 24 sets the actual frequency and the quality factor of the block 20.

The control unit 24 comprises a mode determining output 30, a frequency determining output 31 and a quality factor determining output 32 coupled to corresponding inputs of the block 20. The apparatus comprises an operator unit 40 informed by the control unit 24 on the recognition and reception of a code through code reception reporting output 33, and the operator unit 40 sends commands to the control unit 24 for starting the code transmission received at code transmission starting input 34.

- 19 -

The operation of the active filter and generator according to the invention will be described first in filter mode. In this mode the pulse width modulator 8 and the pulse width adjusting block 12 do not receive enable signal through the mode control input F/O (Fig.1), and the controlled feedback circuit 7 can be considered as being switched off.

The operational amplifiers 1, 2 and 3 form a closed loop, and owing to the specific realization of the capacitive feedback impedances 4 and 5 the arrangement will have a transfer function between the signal input $S_{in}$ and the filter output $F_{out}$ corresponding to that of a band pass filter. The medium frequency of the pass band can be adjusted in two ways. In the first way the coupling member 6 is designed as shown in Fig. 6, in which the controlled switch shown in Figs. 5 or 6 is coupled to input $\underline{f}$ of the T-member. By changing the attenuation of the T-member the frequency of the band pass filter can be changed within wide limits.

A specific feature of the arrangements lies in that with appropriate adjustment of the feedback impedances the quality factor of the band-pass filter varies in a practically negligible extent only if the frequency is changed within a practical range of two octaves. In this way the tuning can be achieved by adjusting a single component only.

As it was mentioned before, the resistor chain shown in Figs. 5 and 6 comprises tapping points and the actually selected tapping point takes a virtual ground potential which is coupled through the field effect transistor associated therewith (or through the analog multiplexer 18) to the inverting input of the operational amplifier 17. The frequency of the band pass filter will take one of the discrete values corresponding to the discrete resistance value of the chain set by the control of a selected one of the inputs $f_c$. This kind of frequency adjustment is simple, stable and free of switching transients and of problems caused by possible contact errors.

In an alternative embodiment the coupling member 6 is made by a constant impedance and the setting of the frequency is made as shown by the dash line in FIG. 1 by combining the frequency adjusting switch 11 and the block 16. The block 16 can be implemented by any of the circuits shown in Figs. 5 and 6 if the terminal x is considered to form the input and the terminal y to form the output. In this embodiment the operational amplifier 17 acts as the operational amplifier 3 of FIG. 1 and the resistor chain between the output and the inverting input of the operational amplifier 17 will correspond to the resistor R1 and the remaining portion of the chain will correspond to the resistor R2. By appropriate control of the frequency determining inputs $f_c$ the ratio of the resistors R1 and R2 can be changed in discrete steps. The setting of the frequency of the band pass filter can be carried out again

- 21 -

0142586

without influencing the value of the quality factor.

The value of the quality factor can be changed by the adjustment of the parallel ohmic branch of the capacitive feedback impedance 4. In FIGs. 2a and 2b the terminal $c$ is connected to the quality factor adjusting switch 15. The switch 15 can be implemented e.g. by the resistor chain of FIGs. 5 and 6 by connecting the terminal $c$ to the terminal $x$ of the chain. In such an embodiment the inputs $f_c$ will correspond to the quality factor adjusting inputs $Q_{in}$. By changing the value of the quality factor the transient phenomena occurring during switching operations can be reduced substantially, since following the detection of an incoming signal the selectivity can be decreased, whereby the energy stored in the selective circuit can be reduced for the time of the switchover operation as it is described in detail in HU patent 169,457. If the quality factor is changed as described hereinabove, then this change can not affect the frequency of the band pass filter.

Although the circuits of FIGs. 5 and 6 are preferable for changing the frequency, it must be clear that the frequency setting can also be realised by any other conventional means e.g. by switches or semiconductor switching elements. Similarly, the circuits of FIGs. 5 and 6 are preferable for the frequency adjusting operations, however, their field of applications can not be limited to the usage in an active filter, but they can be used preferably in cases, in which a divider, an attenuation or the gain of an operational amplifier should be changed according to predetermined discrete values so that the change be free of noises, fast and reliable.

In the second generator mode of operation the active filter acts as an oscillator and generates a sinus signal in the preset frequency. This mode of operation can be set by the state of the mode control input F/O. This state associated with the generator mode enables through the input 84 the operation of the pulse-width modulator 8, and the controlled feedback circuit 7 is connected between the inverting input of the operational amplifier 3 and the output of the operational amplifier 1. Depending on the resistance value of the feedback circuit 7 the condition for oscillation can take place for the closed loop system consisting of the operational amplifiers 1, 2 and 3. If this resistance value is smaller than the critical one corresponding to the condition of oscillation, then the amplitude of oscillation will be increasing, while if this value is higher than the critical one, the amplitude of oscillation decreases and the oscillation stops. The frequency of oscillation will be that of the band pass filter set in the first mode of operation. The value of the quality factor determined the noise band-width and the distortion of the generated sine waves. Let us suppose, that the resistance of the feedback circuit 7 is such that the condition of oscillation is met. As it is known in the art, if in an oscillator arrangement the condition

- 23 -    0142586

of oscillation is met, then the oscillation will be started from the ever existing noise with an exponentially increasing amplitude, and the amplitude increase goes on until the circuit starts to take non-linear properties, and due to the associated change in the conditions for oscillation, the amplitude of oscillation gets stabilized. The rate of increase in the amplitude of oscillation is determined by the extent of feedback reserve over to the minimum feedback required for the starting of oscillation. In a started (triggered) oscillator mode of operation the fast start of oscillation and the fast stabilization of the amplitude of oscillation should be provided for. With known technology the only way for fullfilling this requirement was the use of a substantial feedback reserve, which was often associated with a frequency change during the start of oscillation.

In the circuit arrangement of FIG. 1 in the beginning of the generator mode of operation a switching pulse of predetermined duration is generated by the pulse-width adjusting block 12, and the circuit of the controlled switch 13 will be closed for the duration of this pulse, whereby the voltage of the reference source 14 is passed through the resistor R4 to the inverting input of the first operational amplifier 1. By the application of this voltage signal an energy of predetermined value is supplied in the closed loop system of operational amplifiers acting together as an oscillator. The amount of the supplied energy can be adjusted by the voltage of the reference source 14 and by the duration of the pulse of the pulse-
-width adjusting block 12. In response to the supplied
energy the feedback system which was without energy
in the beginning will not start oscillating from the noise
level to reach the stabilized level any more, but from
a level defined by the amount of the energy supplied,
which can be set to be close to the required oscillation
level. By this measure the feedback overcoupling (reserve)
can be reduced to a minimum, which remarkably increases
the stability and accuracy of the preset frequency.
The starting energy impact in the system shortens the
time required for starting the oscillation.

The fullfillment of the condition of oscillation depends
on the value of the feedback circuit 7. In view of the
fact that the operational amplifiers 1, 2 and 3 function
correctly if during operation no overdriving or non-linear
operation takes place, the adjustment of the oscillation
amplitude should be made by a separate control system.
This task is made by the pulse-width modulator 8, which
passes the clock pulses of the clock 9 to the feedback
circuit 7 in accordance with an appropriate control.

The operation of the pulse-width modulator 8 will be
described in connection with FIG. 7. The feedback circuit 7
is made by a field effect transistor having a channel
resistance defined by the signal coupled to the control
electrode thereof. The clock 9 generates clock pulses
with a frequency being at least by a decimal order of
magnitude higher than the highest operational frequency of the oscillator. The clock pulses alternatively open and close the feedback circuit 7, and the ratio of the on an off sections is determined by the setting of the pulse-width modulator 39. In this way the channel resistance of the circuit 7 is changed periodically.

Let us suppose that the oscillation has already started and from the output of the operational amplifier 1 a sine wave of predetermined amplitude is coupled to the input 81 of the level setting circuit 35. Following an appropriate attenuation the level detector 36 provides a DC voltage proportional to the amplitude of oscillation which is passed to an input of the difference circuit 37. The difference circuit 37 generates the difference of the output of the reference source 10 and the DC voltage of the level detector 36, and this difference voltage is amplified by the error signal amplifier 38 and passed to the modulation control input of the pulse-width modulator 39. The average channel resistance of the feedback circuit 7 is defined by the on-off ratio of the control pulses derived by the pulse-width modulator 39 which, however, depends on the relation of the oscillation amplitude to the voltage of the reference source 10.

It can be understood that if the amplitude level increases, this will be accompanied by a decreased on-off rate of the control pulses of the feedback circuit 7 which result in a decrease in the amplitude of oscillation. If the oscillation amplitude decreases, the on-off rate of the control pulses increases, whereby the oscillation amplitude stops decreasing. The above described amplitude regulation based on the pulse-width modulation control provides for an effective means to stabilize the oscillation amplitude.

This amplitude control is fast and stable and it does not require the usage of non-linear elements in the main oscillator circuit, thus the distorsion of the generated signals will be at minimum. On the basis of test measurements it has been experienced that the oscillation parameters will not be influenced by the periodically changing value of the feedback resistor due to the pulse-width modulation control if the clock frequency is kept sufficiently high relative to the oscillator frequency.

In an alternative embodiment (not shown in the drawing) the pulse width modulator 8, the clock 9 and the reference source 10 can be omitted. In that case the feedback impedance circuit 7 should be designed as a controllable limiter circuit. If in addition to this property the controllable limiter circuit provides for a phase reversal of $180^{\circ}$, then the end of the circuit 7 which is connected according to FIG. 1 to the common terminal of the resistors TR1 and R2 can be disconnected from this common terminal and coupled to the inverting input of the first operational amplifier 1. In this arrangement the feedback circuit 7 is located in parallel with the feedback impedance 4. The amplitude of oscillation is determined by the impedance of the limiter circuit and by the voltage level at which it starts limiting. According to practical measurements the distorsion of the

- 27 -

0142586

generated signal is negligible although a non-linear element is used in the feedback circuit. The main oscillator circuit, however, does not comprise any non--linear element.

The above described active filter and generator circuit has a constructional design which can well be implemented by an integrated circuit, since it does not comprise any inductive element. The circuit provides for the independent electronic settings of the frequency and the quality factor, and for the fast and accurate starting of the oscillation in the generator mode and it ensures a significant spare in component costs, since the same components are used both for reception and generation of the signals, as well as for the adjustment of the parameters in the receiving and generator modes. It will be apparent for the man skilled in the art that the way of operation remains substantially unchanged if in the closed loop the order of the three operational amplifiers 1, 2 and 3 and the associated feedback impedance is interchanged or modified. The above described properties of the active filter and generator circuit are particularly important in the receipt and generation of sequential signal series in radio telephone systems. The operation of such an exemplary application will be described in connection with FIG. 8.

The transmitter-receiver sets operating in radio--telephone systems detect the calls directed to them by means of receiving and detecting the specific sequential calling signals assigned individually to them, and they can transmit a call to a particular other radio station by generating the sequential code of the called radio station. The circuits providing for the detection and the generation of the sequential code signals have therefore an outstanding importance in the reliable operation of the radio station.

The circuit shown in FIG. 8 indicates those blocks of a radio station only which participate in the detection and generation of the calling signal. The receiver 21 receives the sequentially incoming calling signals, and the amplitude limiter 22 passes the signals with a constant level through the selector 23 to the signal input $S_{in}$ of the block 20. In reception mode the control unit 24 sets the selector 23 in on-condition and the generator audio path switch 27 in off-condition. A T/R code program store 25 passes an information regarding the programmed own code to the control unit 24, which in response to this information sets the frequency of the block 20 to the first frequency of the own code.

If the first frequency of a received sequential code coincides with the first frequency of the own code, then the block 20, which operates now as a band pass filter, passes this signal to its filter output $F_{out}$ which is detected by the level comparator 26 and reported to code receiving input 29 of the control unit 24. The reception of any other frequencies is effectively blocked by the filter, and the level comparator 26 can respond only to the receipt of the required own frequency.

The control unit 24 decreases the quality factor upon receipt of the first own frequency and then changes over to its second own frequency, whereafter the quality factor is increased again. If the second frequency of the incoming signal is the same as the second own frequency, then this fact will be reported again to the control unit 24 as described above, and the response will be similar. If such a coincidence is detected during receipt of all incoming frequencies, this means the detection of a call directed toward this radio station, and the control unit 24 sends through its code reception output 33 a signal to the operator unit 40 of the station and the connection can be established.

In case of code generation the operator unit 40 sets the code generation starting input 34 of the control unit 24 in an active state, the control unit 24 controls the generator audio path switch 27 to on-condition, changes the state of the mode control input F/O and sets the frequency of the block 20 to the first frequency of the own code which is to be transmitted. In that case the block 20 starts to oscillate on the first required frequency as an oscillator and the oscillator signal is passed through the generator audio path switch 27 to the modulation input of the transmitter 28. The control unit 24 ensures that the code generation lasts for the required time. During transmission of the second own frequency the control unit 24 sets the second own programmed frequency and the oscillator will be started again or kept continuously running. This generation is continued until the whole code sequence is transmitted, whereafter the control unit 24 switches over to receiving mode.

It can be seen that the requirements of the above described sophisticated way of operation can be fully satisfied by the properties of the block 20 which enables the implementation of a simple code receiving and transmitting means.

Claims:

1. A filter arrangement with active elements, comprising three operational amplifiers inserted in a closed loop chain, two of the operational amplifiers comprise capacitive and the third one comprises an ohmical feedback impedance, in which the output of the first operational amplifier is coupled through a coupling member to the input of the second operational amplifier, and the output of the third operational amplifier is coupled through a resistor to the input of the first operational amplifier, c h a r a c t e r i z e d in, that the first and second operational amplifiers (1,2) comprise capacitive feedback impedances (4,5), the first of the capacitive feedback impedances (4) includes a pair of parallel branches, the first branch comprises a capacitance and the second branch comprises an ohmical circuit, the ohmical circuit has a quality factor determining terminal (c) which is connected to a quality factor adjusting switch (15), and the second capacitive feedback impedance (5) and/or the capacitive branch of the first capacitive feedback impedance (4) comprises a series RC member, and the arrangement comprises a frequency adjusting switch (11) coupled to the coupling member (6) or to the third operational amplifier (3).

2. The filter arrangement as claimed in claim 1, c h a r a c t e r i z e d in, that the ohmical circuit of the first capacitive feedback impedance (4) consists of a T-attenuator and the cross member of the T-attenuator
is coupled to the quality factor determining terminal (c).

3. The filter arrangement as claimed in claim 1,
c h a r a c t e r i z e d  in, that the coupling member (6)
is made of a T-attenuator having a cross member coupled
to the frequency adjusting switch (11).

4. The filter arrangement as claimed in claim 1,
c h a r a c t e r i z e d  by comprising a controlled
feedback circuit (7) coupled between an input of the third
operational amplifier (3) and the output of the first
operational amplifier (1), the controlled feedback circuit
(7) comprises a control input connected to a mode control
input (F/O) of the arrangement.

5. The filter arrangement as claimed in claim 1,
c h a r a c t e r i z e d  by comprising a controlled
feedback circuit (7) coupled between an input and the
output of the first operational amplifier (1), the
controlled feedback circuit (7) comprises a control input
connected to a mode control input (F/O) of the arrangement.

6. The filter arrangement as claimed in claims 4 or 5,
c h a r a c t e r i z e d  by comprising a pulse-width
modulator (8) as an oscillation level control means
coupled to the control input of the feedback circuit (7),
a clock (9) coupled to the modulator (8), a reference
source (10) for determining the amplitude of oscillation which is coupled to the modulator (8), and the modulator (8) has an input receiving an oscillation signal from said chain,and said connection between the mode control input (F/O) and the control input of the feedback circuit (7) is made through the modulator (8).

7. The filter arrangement as claimed in claim 6, c h a r a c t e r i z e d  in that the controlled feedback circuit (7) is made by a field effect transistor.

8. The filter arrangement as claimed in claim 6, c h a r a c t e r i z e d  by comprising a further reference source (14), a controlled switch (13) for connecting the further reference source (14) to one of said operational amplifiers (1,2,3), and a pulse-width adjusting block (12) connected between the control input of the controlled switch (13) and the mode control input (F/O).

9. The filter arrangement as claimed in claim 1, c h a r a c t e r i z e d  in that the frequency adjusting switch (11) comprises a resistor chain of resistors connected in series, an operational amplifier (17) with an output coupled to an end terminal of the chain, switching elements connecting respective intermediate terminals of the chain to the inverting input of the operational amplifier (17) and the non-inverting input of the operational amplifier (17) is connected to ground potential.

10. The filter arrangement as claimed in claim 9, c h a r a c t e r i z e d in that the switching elements are made of field effect transistors ($T_0$ ... $T_{n-1}$).

11. The filter arrangement as claimed in claim 9, c h a r a c t e r i z e d in, that the switching elements are made by an analog multiplexer (18).

12. The filter arrangement as claimed in claim 9, c h a r a c t e r i z e d in, that the quality factor adjusting switch (15) is designed as the frequency adjusting switch (11).

13. The filter arrangement as claimed in claim 9, c h a r a c t e r i z e d in that the free end of the resistor chain is connected to the frequency control input of the coupling member (6), and the control inputs of the switching elements forming frequency determining inputs ($f_c$) of the arrangement.

14. The filter arrangement as claimed in claim 9, c h a r a c t e r i z e d in, that the third operational amplifier (3) is made by the operational amplifier (17) of the frequency adjusting switch (11), the feedback resistor (R1) of the third operational amplifier (3) is made by a portion of the resistor chain, and the control inputs of the switching elements forming frequency determining inputs ($f_c$) of the arrangement.

15. A circuit arrangement for the reception and generation of sequential signal series, particularly for radiotelephone transmitters and receivers by using the active filter arrangement as claimed in any of claims 4 to 14, comprising an amplitude limiter coupled to the input, a selector audio path switch, a generator audio path switch, a level comparator coupled to the filter output of the active filter arrangement block, a control unit and an operator unit coupled to the control unit, c h a r a c t e r i z e d in, that the mode determining output (30) of the control unit (24) is coupled to control inputs of the selector audio path switch (23) and of the generator audio path switch (27) and to the mode determining input (F/O) of the filter arrangement block (20), the frequency determining output (31) of the control unit (24) is coupled to the frequency determining input ($f_c$) of the filter arrangement block (20), the quality factor determining output (32) of the control unit (24) is connected to the quality factor determining input ($Q_{in}$) of the filter arrangement block (20), the output of the selector audio path switch (23) is connected to the signal input ($S_{in}$) of the filter arrangement block (20), the input of the generator audio path switch (27) is connected to the oscillator output (Osc) of the filter arrangement block (20) and the output of the level comparator (26) is coupled to code receiving input (29) of the control unit (24).

16. A circuit arrangement for adjusting discrete resistance values, particularly for the active filter arrangement as claimed in any of claims 1 to 14, comprising a predetermined number of resistors connected in a chain and switching elements coupled to intermediate terminals of the chain, c h a r a c t e r i z e d  by comprising an operational amplifier (17) having an output coupled to an end terminal of the chain and having a first input coupled to a common terminal of the switching elements (18, $T_o...T_{n-1}$) and a second input connected to a ground potential, and the switching elements have respective control inputs of which only one being controllable at a time.

Fig. 1

Fig.2.a

Fig.3

Fig.2.b

Fig.4

Fig.7

3/4

0142586

Fig. 5

Fig. 6

Fig. 8

0142586

## European Patent Office

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | ELECTRONICS AUSTRALIA, vol. 37, no. 4, July 1975, page 77, Sungravure Pty Ltd., Sydney, AU; A. TAFLOV: "Analog-computer-type active filter" * Whole document * | 1 | H 03 H 11/12 H 03 B 5/20 |
| A | THE TRANSACTIONS OF THE IECE OF JAPAN, vol. E60, no. 10, October 1977, pages 557-558, Tokyo, JP; T. YAGI et al.: "Characteristics of AM-PM transformation of modulated waves in nonlinear transmission lines" * Whole document * | 1 | |
| A | IBM TECHNICAL DISCLOSURE BULLETIN, vol. 23, no. 9, February 1981, pages 4214-4215, New York, US; J.A. ZUMBADO: "Switched resistor resonator for an active bandpass filter" * Whole document * | 1 | TECHNICAL FIELDS SEARCHED (Int. Cl. ³) H 03 H H 03 B |
| A | US-A-3 760 289 (GUNNAR HURTIG) * Whole document * | 1,7,9 | |
| A | US-A-3 803 429 (A.B. WIECZOREK et al.) * Whole document * | 1 | |

The present search report has been drawn up for all claims

| Place of search THE HAGUE | Date of completion of the search 31-07-1984 | Examiner COPPIETERS C. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82